# EUROPÄISCHE PATENTSCHRIFT

(11) **EP 4 353 878 B1**
(45) Veröffentlichungstag und Bekanntmachung des Hinweises auf die Patenterteilung: **23.04.2025**
(21) Anmeldenummer: 22201615.6
(22) Anmeldetag: 14.10.2022
(51) Int. Cl.: C30B 15/04, C30B 29/06

(54) **VERFAHREN ZUR HERSTELLUNG EINES EINKRISTALLS AUS SILIZIUM, DER MIT DOTIERSTOFF VOM N-TYP DOTIERT IST, GEMÄSS DER CZ-METHODE**
METHOD FOR PRODUCING A SINGLE CRYSTAL OF SILICON DOPED WITH N-TYPE DOPANT ACCORDING TO THE CZ METHOD
PROCÉDÉ DE FABRICATION D'UN MONOCRISTAL DE SILICIUM DOPÉ PAR UN DOPANT DE TYPE N SELON LA MÉTHODE CZ

(43) Veröffentlichungstag der Anmeldung: 17.04.2024
(73) Patentinhaber: Siltronic AG, 81677 München (DE)
(72) Erfinder: Daniel, Matthias, 09599 Freiberg (DE); Huber, Johann-Andreas, 83404 Ainring (DE); Raming, Georg, 84367 Tann (DE)
(74) Vertreter: Staudacher, Wolfgang

(56) Entgegenhaltungen:
- WO-A1-2021/115904
- US-A1- 2010 294 999

## Beschreibung

Gegenstand der Erfindung ist ein Verfahren zur Herstellung eines Einkristalls aus Silizium, der mit Dotierstoff vom n-Typ dotiert ist, durch Ziehen des Einkristalls in einer Reaktorkammer gemäß der CZ-Methode aus einer Schmelze, die in einem Tiegel enthalten ist.

### Stand der Technik / Probleme

Einkristalle aus Silizium, die vergleichsweise viel Dotierstoff vom n-Typ enthalten, werden hauptsächlich als Rohstoffe zur Herstellung von Halbleiter-Leistungsbauelementen benötigt.

Sublimierende Dotierstoffelemente wie Phosphor oder Arsen oder Antimon werden üblicherweise in gasförmigem Zustand mit der Schmelze in Kontakt gebracht. Dabei besteht die Herausforderung, ungeachtet eines hohen Dampfdrucks des Dotierstoffs, eine ausreichend hohe Konzentration an Dotierstoff in der Schmelze zu gewährleisten. Darüber hinaus muss der Dotierstoffeintrag möglichst genau kontrolliert werden, um zu vermeiden, dass sich Versetzungen bilden, die das einkristalline Wachstum Kristalls beenden.

WO 2021/115 904 A1 beschreibt ein Verfahren, wonach in einer Sublimations-Einrichtung Dotierstoffgas erzeugt wird und zusammen mit einem Trägergas durch eine Rohrleitung in die Reaktorkammer bis zu einem Ringkanal an einem unteren Ende eines Hitzeschilds geleitet wird.

In US 2010/0 294 999 A1 ist beschrieben, festen Dotierstoff in einer beheizten Einheit innerhalb der Reaktorkammer zu sublimieren und die Sublimations-Geschwindigkeit zu regeln sowie dabei entstehendes Dotierstoffgas zusammen mit einem Trägergas durch eine Rohrleitung zur Schmelze zu leiten.

Die Aufgabe dieser Erfindung ist es, auf einfache Weise zu erreichen, dass die Dotierstoff-Verteilung über die axiale Länge eines zylindrischen Abschnitts des Einkristalls möglichst gleichmäßig ist, unabhängig von der Länge des zylindrischen Abschnitts.

Gelöst wird die Aufgabe durch ein Verfahren zur Herstellung eines Einkristalls aus Silizium, der mit Dotierstoff vom n-Typ dotiert ist, durch Ziehen des Einkristalls, der von einem Hitzeschild mit einem unteren Ende umgeben ist, in einer Reaktorkammer gemäß der CZ-Methode aus einer Schmelze, die in einem Tiegel enthalten ist, umfassend
das Erhitzen von festem Dotierstoff in einem Dotierstoff-Tiegel einer Sublimier-Einheit außerhalb der Reaktorkammer mittels einer Tiegel-Heizung bis auf eine Temperatur, bei der gasförmiger Dotierstoff gebildet wird;
das Zuführen des gasförmigen Dotierstoffs in Form eines Volumenstroms von Dotierstoffgas durch eine Rohrleitung mit einem unteren Ende zu einer Oberfläche der Schmelze, gekennzeichnet durch
das Bringen eines Regelventils zwischen der Sublimier-Einheit und der Reaktorkammer in einen vorgegebenen Öffnungszustand, sobald eine Druckdifferenz des Drucks in der Sublimier-Einheit und des Drucks in der Reaktorkammer auf einen vorbestimmten Wert angewachsen ist; und
das Regeln des Öffnungszustands des Regelventils mit einem Soll-Druck in der Sublimier-Einheit als Führungsgröße und der Druckdifferenz als Regelgröße der Regelung.

Mittels der Erfindung kann während des Ziehens eines Einkristalls ein nahezu gleichbleibender Strom an Dotierstoffgas über einen vergleichsweisen langen Zeitraum zur Schmelze geleitet werden und fester Dotierstoff bei Bedarf nachbeladen werden, um eine weitere Zufuhr von Dotierstoffgas zur Schmelze zu gewährleisten. Die Lösung ist einfach und zuverlässig.

Der gasförmige Dotierstoff wird ohne oder zusammen mit einem Trägergas wie Argon als Volumenstrom von Dotierstoffgas zur Schmelze geleitet. Das Trägergas wird insbesondere eingesetzt, um den Strom an gasförmigen Dotierstoff zu stabilisieren, wenn die Konzentration an gasförmigem Dotierstoff vergleichsweise gering ist. Die Zufuhr von Trägergas wird vorzugsweise mittels eines Massendurchfluss-Reglers (MFC) geregelt.

Fester Dotierstoff kann vor und/oder während des Ziehens eines Einkristalls in den Dotierstoff-Tiegel gefüllt werden. Zum Nachbeladen des Dotierstoff-Tiegels mit festem Dotierstoff wird die Rohrleitung außerhalb der Reaktorkammer unterbrochen, indem das Regelventil (control valve) vollständig geschlossen wird. Vorzugsweise wird sicherheitshalber zusätzlich ein Trennventil aktiviert, das zwischen der Reaktorkammer und dem Regelventil angeordnet sein kann. Das Trennventil stellt sicher, dass unabhängig von der Dichtigkeit des Regelventils ein sicherer Zugang zur Sublimier-Einheit gewährleistet ist. Vorzugsweise wird die Temperatur des Dotierstoff-Tiegels und damit die Temperatur in der Sublimier-Einheit, kurz bevor der darin enthaltene feste Dotierstoff aufgebraucht ist, angehoben. Dadurch wird gewährleistet, dass der Dotierstoff vollständig entwichen ist, bevor die Sublimier-Einheit geöffnet wird. Das Entweichen des Dotierstoffs kann durch den damit verbundenen Druckabfall in der Sublimier-Einheit verfolgt werden.

Die Sublimier-Einheit umfasst ein Gehäuse, in dem der Dotierstoff-Tiegel untergebracht ist und das einen Zugang zum Dotierstoff-Tiegel gewährt. Das Gehäuse ist vorzugsweise doppelwandig ausgeführt und kann mittels eines Kühlkreislaufs aktiv gekühlt werden.

Neben der Tiegel-Heizung sind vorzugsweise weitere Heizungen vorhanden, insbesondere um einer Resublimation des Dotierstoffs entgegenzuwirken, beispielsweise eine Innenraum-Heizung für das Gehäuse, eine Außenheizung für das Regelventil und das gegebenenfalls vorhandene Trennventil und die außerhalb der Reaktorkammer befindlichen Bereiche der Rohrleitung. Eine weitere Heizung kann zum Beheizen von Ventilen zum Einleiten des Trägergases und von Umgebungsluft in die Sublimier-Einheit vorgesehen sein. Für roten Phosphor als Dotierstoff beträgt die Sublimationstemperatur 362 °C bei einem Druck von 10000 Pa, für Arsen ist die Sublimationstemperatur bei diesem Druck 508 °C. Insbesondere die Temperatur der Dotierstoff führenden Rohrleitung sollte über der entsprechenden Sublimationstemperatur liegen.

Der Druck wird in der Reaktorkammer und in der Sublimier-Einheit gemessen. Der Öffnungszustand des Regelventils wird von der Differenz der Drücke in der Sublimier-Einheit und der Reaktorkammer abhängig gemacht und mittels eines Aktuators des Regelventils eingestellt. Der Aktuator stellt den Hub (stroke) eines Elements ein, das den Durchfluss durch das Ventil bestimmt, beispielsweise die Position eines Stopfens, der den Durchfluss durch das Ventil unterbrechen kann. Der Aktuator arbeitet vorzugsweise elektrisch und bildet das Stellglied einer Regelung. Während des Zuführens des gasförmigen Dotierstoffs zur Oberfläche der Schmelze ist der Druck in der Sublimier-Einheit größer als der Druck in der Reaktorkammer.

Um zu erreichen, dass der Volumenstrom von Dotierstoffgas während eines Vorgangs des Ziehens eines Einkristalls aus Silizium in reproduzierbarer und kontrollierter Weise zur Schmelze gelangt, wird der Volumenstrom vorzugsweise erst nach einer Stabilisierungsphase durch das Regelventil geleitet. Die Stabilisierungsphase umfasst das Erhitzen des Dotierstoff-Tiegels bei geschlossenem Regelventil auf eine Temperatur, die unter der Temperatur liegt, bei der der feste Dotierstoff zu sublimieren beginnt, bis der Druck in der Sublimier-Einheit auf einen vorbestimmten Wert angestiegen ist. Nach der Stabilisierungsphase wird der Dotierstoff-Tiegel auf eine Temperatur erhitzt, die über der Temperatur liegt, bei der der feste Dotierstoff zu sublimieren beginnt. Die Geschwindigkeit (evaporation rate), mit der der feste Dotierstoff sublimiert, wird insbesondere durch die Temperatur bestimmt, auf die der Dotierstoff-Tiegel erhitzt wird. Ein einsetzender weiterer Druckanstieg in der Sublimier-Einheit bei gleichbleibender oder leicht steigender Temperatur der Heizung des Dotierstoff-Tiegels zeigt den Beginn der Sublimation an. Das Regelventil wird geöffnet, sobald die Differenz des Drucks in der Sublimier-Einheit und des Drucks in der Reaktorkammer auf einen vorbestimmten Wert angewachsen ist. Die Druckdifferenz beträgt vorzugsweise mindestens 1000 Pa, besonders bevorzugt 5000 bis 10000 Pa. Anschließend wird der Öffnungszustands des Regelventils mittels eines Aktuators des Regelventils im Rahmen einer Regelung geregelt, mit einem Soll-Druck in der Sublimier-Einheit als Führungsgröße und der Druckdifferenz als Regelgröße der Regelung. Die Regelung ist vorzugsweise als PID-Regelung ausgestaltet. Der Druck bleibt in der Sublimier-Einheit mit Ausnahme von periodischen, der Regelung geschuldeten Druckschwankungen nahezu konstant, bis es zu einem Druckabfall kommt, der wegen des zur Neige gehenden Vorrats an festem Dotierstoff im Dotierstoff-Tiegel eintritt. Fällt der Druck auf einen vorgesehenen Wert, wird auch das Regelventil geschlossen.

Der Dotierstoff-Tiegel kann mit festem Dotierstoff nachbeladen werden, sollte es notwendig sein, aus der Schmelze entwichenen Dotierstoff zu ersetzen. Das kann der Fall sein, wenn nach einer Versetzungsbildung der Kristall zurückgeschmolzen und ein neuer Anlauf zum Ziehen eines Einkristalls begonnen wird oder wenn wegen der Länge des zylindrischen Abschnitts des wachsenden Einkristalls der Vorrat an Dotierstoff in der Sublimier-Einheit erschöpft ist. Dann wird die Sublimier-Einheit bei geschlossenem Regelventil und gegebenenfalls geschlossenem Trennventil gespült und abgekühlt und die erforderliche Menge an zusätzlichem festen Dotierstoff im Dotierstoff-Tiegel abgelegt.

Das Zuführen des Volumenstroms von Dotierstoffgas durch die Rohrleitung zur Oberflache der Schmelze beginnt vorzugsweise vor dem Ziehen eines zylindrischen Abschnitts des Einkristalls, beispielsweise gleich nach dem In-Kontakt-Bringen eines Impflings-Kristalls mit der Schmelze oder vor oder während des Ziehens eines konusförmigen Abschnitts des Einkristalls. Es ist aber auch möglich, erst am Anfang oder während des Ziehens des zylindrischen Abschnitts damit zu beginnen. Unabhängig davon kann die Schmelze bereits vor dem Zuführen des Volumenstroms von Dotierstoffgas mit Dotierstoff angereichert sein, beispielsweise indem eine Dotierglocke mit festem Dotierstoff in die Schmelze aus Silizium getaucht wird.

Das untere Ende der Rohrleitung, an dem der Volumenstrom von Dotierstoffgas austritt, ist vorzugsweise auf derselben Höhe über der Schmelze angeordnet, wie das untere Ende eines Hitzeschilds, der den wachsenden Einkristall umgibt. Des Weiteren befindet sich das untere Ende der Rohrleitung vorzugsweise zwischen dem unteren Ende des Hitzeschilds und der Wand des Tiegels mit der Schmelze. Es ist auch bevorzugt, die Rohrleitung in der Reaktorkammer so anzuordnen, dass sie durch die Wand des Hitzeschilds hindurchführt. Die Rohrleitung besteht im Bereich der Wand der Reaktorkammer, wo sie mit Wasser gekühlt werden kann, vorzugsweise aus Metall, beispielsweise aus Edelstahl, und ist dort einer Temperatur von nicht mehr als 600 °C ausgesetzt. In der Umgebung des wachsenden Einkristalls und wärmerer Grafit-Teile, der hot zone, muss temperaturfestes Material verwendet werden, beispielsweise Grafit, ein carbon fibre reinforced composit-Werkstoff (CFC) und oder Quarz. Es ist besonders bevorzugt, die Rohrleitung in der Reaktorkammer in einen oberen Abschnitt aus Edelstahl, einen mittleren Abschnitt aus CFC und einen unteren Abschnitt aus Quarz, der an seinem unteren Ende mit CFC ummantelt ist, zu untergliedern. Die Ummantelung schützt das Quarzrohr vor Überhitzung.

Die Erfindung wird nachfolgend unter Bezugnahme auf Zeichnungen weiter beschrieben.

### Kurzbeschreibung der Figuren

**Fig. 1** zeigt einen Vertikalschnitt durch eine Reaktorkammer und eine Sublimier-Einheit, die zur Umsetzung der Erfindung geeignet sind.
**Fig. 2** zeigt einen vergrößerten Ausschnitt von Fig. 1
**Fig. 3** zeigt den Verlauf des spezifischen elektrischen Widerstands R eines Einkristalls aus Silizium in Abhängigkeit der axialen Position P des zylindrischen Abschnitts des Einkristalls.

### Liste der verwendeten Bezugszeichen

- **1**: Reaktorkammer
- **2**: Sublimier-Einheit
- **3**: Tiegel
- **4**: Schmelze
- **5**: Einkristall
- **6**: Rohrleitung
- **7**: Heizvorrichtung
- **8**: Ziehvorrichtung
- **9**: Magnetfeld-Spule
- **10**: Hitzeschild
- **11**: Dotierstoff-Tiegel
- **12**: Tiegel-Heizung
- **13**: Wägezelle
- **14**: Massendurchfluss-Regler
- **15**: Controller
- **16**: Regelventil
- **17**: Trennventil
- **18**: oberer Abschnitt
- **19**: mittlerer Abschnitt
- **20**: unterer Abschnitt
- **21**: CFC-Mantel

### Detaillierte Beschreibung erfindungsgemäßer Ausführungsbeispiele

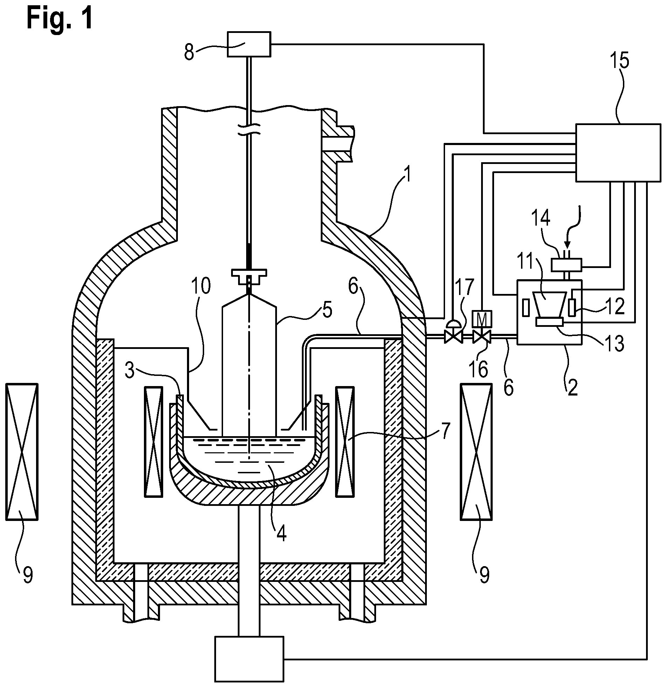

Fig. 1 zeigt einen Vertikalschnitt durch eine Reaktorkammer 1 und eine Sublimier-Einheit 2, die zur Umsetzung der Erfindung geeignet sind. Die nachfolgende Beschreibung lässt einige gezeigte Merkmale unerwähnt, die zur Erklärung der Erfindung nichts beitragen. In der Reaktorkammer 1 ist ein Tiegel 3 mit einer Schmelze 4 aus Silizium angeordnet, die im Verlauf des Ziehens eines Einkristalls 5 aus der Schmelze mit gasförmigem Dotierstoff vom n-Typ, der durch eine Rohrleitung 6 zur Oberfläche der Schmelze 4 geführt wird, dotiert wird. Die Schmelze 4 wird mittels einer Heizvorrichtung 7, die den Tiegel 3 umgibt, flüssig gehalten. Der Einkristall 5 ist von einem Hitzeschild 10 umgeben, der Wärmestrahlung der Heizvorrichtung 7 abschirmt. Während der Einkristall 5 mittels einer Ziehvorrichtung 8 gedreht und aus der Schmelze gezogen wird, wird der Tiegel 3 angehoben und gedreht. Das Beaufschlagen der Schmelze 4 mit einem Magnetfeld, beispielsweise einem horizontalen Magnetfeld, mittels einer oder mehrerer Magnetfeld-Spulen 9, die um die Reaktorkammer 1 herum angeordnet sind, ist möglich, aber nicht zwingend notwendig. Während des Ziehens des Einkristalls 5 wir die Reaktorkammer 1 gespült, beispielsweise mittels eines Stroms von Argon, der durchgeleitet wird.

Der gasförmige Dotierstoff wird in der Sublimier-Einheit 2 erzeugt, die sich außerhalb der Reaktorkammer befindet, und von dort in Form eines Volumenstroms von Dotierstoffgas durch die Rohrleitung 6 zur Oberfläche der Schmelze 4 geführt. Der Volumenstrom kann anteilig Trägergas, beispielsweise Argon enthalten, das über einen Massendurchfluss-Regler 14 in die Sublimier-Einheit geleitet wird. Zum Erzeugen des gasförmigen Dotierstoffs wird fester Dotierstoff, beispielsweise roter Phosphor, in einen Dotierstoff-Tiegel 11 gefüllt und der Dotierstoff-Tiegel 11 mittels einer Tiegel-Heizung 12 in der Sublimier-Einheit 2 erhitzt. Die Sublimier-Einheit 2 kann über eine Wägezelle 13 verfügen, die über das aktuelle Gewicht an festem Dotierstoff im Dotierstoff-Tiegel 11 informiert. Auf dem Weg durch die Rohrleitung 6 passiert der Volumenstrom von Dotiergas nach dem Verlassen der Sublimier-Einheit 2 und vor dem Eintritt in die Reaktorkammer 1 ein Regelventil 16 und gegebenenfalls ein Trennventil 17.

Der Druck und die Temperatur in der Reaktorkammer 1 und in der Sublimier-Einheit 2 werden von Sensoren an einen Controller 15 übermittelt, der zur Regelung der Zufuhr von Dotierstoffgas zur Oberfläche der Schmelze 4 eingesetzt wird. In der dargestellten Ausführungsform wird der Controller 15 auch verwendet, um den Ziehprozess zu steuern, beispielsweise das Drehen und Herausziehen des Einkristalls 5 und das Drehen und Anheben des Tiegels 3. Zum Initiieren der Zufuhr von gasförmigen Dotierstoff zur Oberfläche der Schmelze 4 wird der Dotierstoff-Tiegel 11 mittels der Tiegel-Heizung 12 erhitzt. Währenddessen hält der Controller 15 das Regelventil 16 und das Trennventil 17 (sofern vorhanden) geschlossen. Zunächst wird der feste Dotierstoff im Dotierstoff-Tiegel 11 auf eine Temperatur unterhalb der Sublimationstemperatur vorerhitzt, bis der Druck in der Sublimier-Einheit 2 eine vorgegebene Schwelle erreicht hat. Anschließend wird die Temperatur der Tiegel-Heizung 12 auf eine Zieltemperatur über der Sublimationstemperatur erhöht, was einen weiteren Druckanstieg in der Sublimier-Einheit 2 zur Folge hat. Der Controller 15 bringt das Regelventil 16 in einen vorgegebenen Öffnungszustand und öffnet gegebenenfalls das Trennventil 17, sobald die Differenz des Drucks in der Sublimier-Einheit 2 und des Drucks in der Reaktorkammer 1 auf einen vorbestimmten Wert angewachsen ist. Im weiteren Verlauf wird der Öffnungszustand des Regelventils 16 geregelt, wobei ein Soll-Druck in der Sublimier-Einheit 2 die Führungsgröße der Regelung ist. Wenn der Vorrat an festem Dotierstoff im Dotierstoff-Tiegel zur Neige geht, fällt der Druck in der Sublimier-Einheit 2. Ist der Druck auf einen vorgegebenen Wert gefallen, werden das Regelventil 16 und gegebenenfalls das Trennventil 17 geschlossen. Danach kann im Bedarfsfall noch während des Ziehens des Einkristalls 5 der Dotierstoff-Tiegel 11 mit weiterem festen Dotierstoff beladen und ein neuer Zyklus des Zuführens des gasförmigen Dotierstoffs zur Oberfläche der Schmelze 4 begonnen werden.

Gemäß der in Fig. 1 gezeigten bevorzugten Ausführungsform hat das untere Ende der Rohrleitung 6 denselben Abstand zur Oberfläche der Schmelze 4 wie das untere Ende des Hitzeschilds 10. Des Weiteren ist bei dieser Ausführungsform der Verlauf der Rohrleitung 6 in der Reaktorkammer 1 so gestaltet, dass die Rohrleitung 6 durch den Hitzeschild 10 hindurchführt, und das untere Ende der Rohrleitung 6 zwischen einer Wand des Tiegels 3 und dem unteren Ende des Hitzeschilds 10 angeordnet ist.

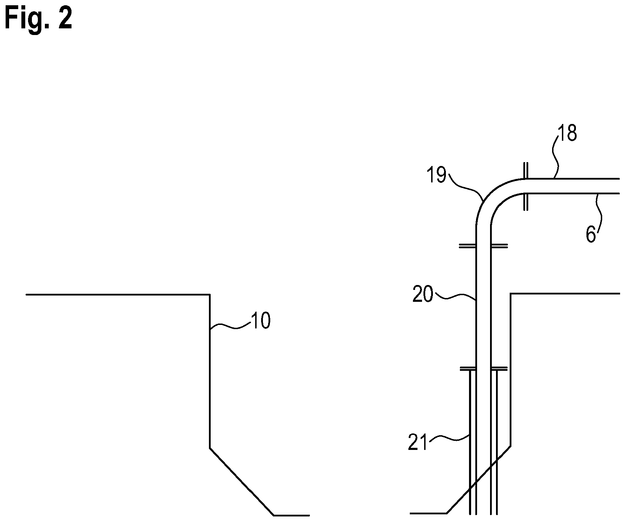

Gemäß dieser bevorzugten Ausgestaltung und der Darstellung in Fig. 2 ist die Rohrleitung 6 in der Reaktorkammer 1 in drei Abschnitte untergliedert und zwar in einen oberen Abschnitt 18 aus Edelstahl, einen mittleren Abschnitt 19 aus CFC (carbon fiber carbon composite) und einen unteren Abschnitt 20 aus Quarz, der an seinem unteren Ende von einem CFC-Mantel umgeben ist.

Die Wirksamkeit der Erfindung wurde am Beispiel der Herstellung eines Einkristalls aus Silizium mit einem Durchmesser von 200 mm in einer Anlage getestet, die im Wesentlichen die in Fig.1 dargestellten Merkmale umfasste. Die Sublimier-Einheit stammte vom Hersteller Riber aus Frankreich.

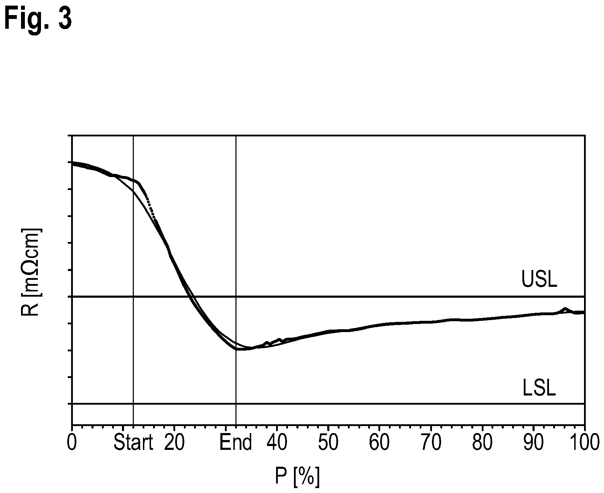

Zunächst wurde der Einkristall bis zu einem oberen, zylindrischen Abschnitt mit einer Grunddotierung durch Phosphor gezogen, der der Schmelze vor dem Ziehen mittels einer Dotierglocke hinzugefügt worden war. Das erfindungsgemäße Verfahren wurde verwendet, um zu zeigen, dass der spezifische elektrische Widerstand des Einkristalls weiter abgesenkt und bis zum Abschluss des Ziehvorgangs nahezu konstant zwischen einer unteren Grenze LSL und einer oberen Grenze USL gehalten werden kann. In Fig. 3 ist das Ergebnis in Form einer Widerstandsmessung dargestellt. Der Verlauf des Widerstands ist vom Anfang des zylindrischen Abschnitts mit Position P = 0 bis zum Ende des zylindrischen Abschnitts mit Position P = 100 gezeigt. Das erfindungsgemäße Zuführen von gasförmigem Dotierstoff in Form eines Volumenstroms von Dotierstoffgas erfolgte während des Ziehens des zylindrischen Abschnitts des Einkristalls zwischen den mit Start und End bezeichneten Positionen. Durch Anwenden des erfindungsgemäßen Verfahrens konnte der spezifische Widerstand im Einkristall auf weniger als 1 mΩcm herabgesetzt werden.

## Patentansprüche

1. Verfahren zur Herstellung eines Einkristalls aus Silizium, der mit Dotierstoff vom n-Typ dotiert ist, durch Ziehen des Einkristalls, der von einem Hitzeschild mit einem unteren Ende umgeben ist, in einer Reaktorkammer gemäß der CZ-Methode aus einer Schmelze, die in einem Tiegel enthalten ist, umfassend
das Erhitzen von festem Dotierstoff in einem Dotierstoff-Tiegel einer Sublimier-Einheit außerhalb der Reaktorkammer mittels einer Tiegel-Heizung bis auf eine Temperatur, bei der gasförmiger Dotierstoff gebildet wird;
das Zuführen des gasförmigen Dotierstoffs in Form eines Volumenstroms von Dotierstoffgas durch eine Rohrleitung mit einem unteren Ende zu einer Oberfläche der Schmelze, **gekennzeichnet durch**
das Bringen eines Regelventils zwischen der Sublimier-Einheit und der Reaktorkammer in einen vorgegebenen Öffnungszustand, sobald eine Druckdifferenz des Drucks in der Sublimier-Einheit und des Drucks in der Reaktorkammer auf einen vorbestimmten Wert angewachsen ist; und
das Regeln des Öffnungszustands des Regelventils mit einem Soll-Druck in der Sublimier-Einheit als Führungsgröße und der Druckdifferenz als Regelgröße der Regelung.

2. Verfahren nach Anspruch 1, **dadurch gekennzeichnet, dass** die Regelung als PID-Regelung ausgestaltet ist.

3. Verfahren nach Anspruch 1 oder Anspruch 2, **dadurch gekennzeichnet, dass** das untere Ende der Rohrleitung denselben Abstand zur Oberfläche der Schmelze hat wie das untere Ende des Hitzeschilds.

4. Verfahren nach einem der Ansprüche 1 bis 3, **dadurch gekennzeichnet, dass** die Rohrleitung durch den Hitzeschild hindurchführt und das untere Ende der Rohrleitung zwischen einer Wand des Tiegels und dem unteren Ende des Hitzeschilds angeordnet ist.

5. Verfahren nach einem der Ansprüche 1 bis 4, **dadurch gekennzeichnet, dass** die Rohrleitung in einen oberen Abschnitt aus Edelstahl, einen mittleren Abschnitt aus CFC und einen unteren Abschnitt aus Quarz, der mit CFC ummantelt ist, gegliedert ist.

6. Verfahren nach einem der Ansprüche 1 bis 5, **dadurch gekennzeichnet, dass** die Rohrleitung zwischen der Sublimier-Einheit und der Reaktorkammer durch ein Trennventil geschlossen wird, bevor der Dotierstoff-Tiegel mit weiterem festem Dotierstoff nachbeladen wird.

7. Verfahren nach einem der Ansprüche 1 bis 6, **dadurch gekennzeichnet, dass** die Temperatur des Dotierstoff-Tiegels, kurz bevor der darin enthaltene feste Dotierstoff aufgebraucht ist, angehoben wird.

## Claims

1. Process for producing a single silicon crystal doped with n-type dopant by pulling the single crystal, surrounded by a heat shield having a lower end, in a reactor chamber by the CZ method from a melt contained in a crucible, comprising
heating solid dopant in a dopant crucible of a sublimating unit outside the reactor chamber by means of a crucible heater to a temperature at which gaseous dopant is formed;
supplying the gaseous dopant in the form of a volume stream of dopant gas through a conduit having a lower end to a surface of the melt, **characterized by** bringing a control valve between the sublimating unit and the reactor chamber into a mandated open state as soon as a pressure difference between the pressure in the sublimating unit and the pressure in the reactor chamber has grown to a predetermined value; and
controlling the open state of the control valve with a setpoint pressure in the sublimating unit as command variable and the pressure difference as controlled variable of the control.

2. Process according to Claim 1, **characterized in that** the control takes the form of PID control.

3. Process according to Claim 1 or Claim 2, **characterized in that** the lower end of the conduit has the same distance from the surface of the melt as does the lower end of the heat shield.

4. Process according to any of Claims 1 to 3, **characterized in that** the conduit passes through the heat shield, the lower end of the conduit being disposed between a wall of the crucible and the lower end of the heat shield.

5. Process according to any of Claims 1 to 4, **characterized in that** the conduit is divided into an upper portion of stainless steel, a middle portion of CFC and a lower portion of quartz clad with CFC.

6. Process according to any of Claims 1 to 5, **characterized in that** the conduit is closed between the sublimating unit and the reactor chamber by an isolation valve before the dopant crucible is reloaded with further solid dopant.

7. Process according to any of Claims 1 to 6, **characterized in that** the temperature of the dopant crucible is raised shortly before the solid dopant contained therein is used up.

## Revendications

1. Procédé de fabrication d'un monocristal de silicium qui est dopé par un dopant de type n, par tirage d'un monocristal qui est entouré d'un bouclier thermique ayant une extrémité inférieure, dans une chambre de réaction par la méthode CZ à partir d'un bain fondu qui est contenu dans un creuset, comprenant le chauffage du dopant solide dans un creuset de dopant d'une unité de sublimation à l'extérieur de la chambre de réaction à l'aide d'un chauffage de creuset jusqu'à une température à laquelle se forme le dopant gazeux ; l'amenée du dopant gazeux sous forme d'un débit volumique de gaz dopant par une tuyauterie ayant une extrémité inférieure, jusqu'à une surface du bain fondu, **caractérisé par**
la mise d'une vanne de régulation entre l'unité de sublimation et la chambre de réaction dans un état d'ouverture prédéfini, dès que la différence entre la pression de l'unité de sublimation et la pression dans la chambre de réaction a augmenté jusqu'à une valeur prédéfinie ; et
la régulation de l'état d'ouverture de la vanne de régulation avec une pression de consigne dans l'unité de sublimation servant de grandeur de commande et de la différence de pression comme grandeur réglée de la régulation.

2. Procédé selon la revendication 1, **caractérisé en ce que** la régulation est conçue comme une régulation PID.

3. Procédé selon la revendication 1 ou la revendication 2, **caractérisé en ce que** l'extrémité inférieure de la tuyauterie se trouve à une distance à la surface du bain fondu égale à celle de l'extrémité inférieure du bouclier thermique.

4. Procédé selon l'une des revendications 1 à 3, **caractérisé en ce que** la tuyauterie traverse le bouclier thermique et que l'extrémité inférieure de la tuyauterie est disposée entre une paroi du creuset et l'extrémité inférieure du bouclier thermique.

5. Procédé selon l'une des revendications 1 à 4, **caractérisé en ce que** la tuyauterie est subdivisée en un tronçon supérieur en acier inoxydable, un tronçon central en CFC et un tronçon inférieur en quartz, gainé de CFC.

6. Procédé selon l'une des revendications 1 à 5, **caractérisé en ce que** la tuyauterie est, entre l'unité de sublimation et la chambre de réaction, obturée par une vanne de séparation avant que le creuset de dopant soit rechargé en un dopant solide supplémentaire.

7. Procédé selon l'une des revendications 1 à 6, **caractérisé en ce qu'**on élève la température du creuset de dopant peu de temps avant épuisement du dopant solide qui y est contenu.
